# EUROPEAN PATENT SPECIFICATION

(11) **EP 0 436 812 B1**
(45) Date of publication and mention of the grant of the patent: **31.08.1994**
(21) Application number: 90122376.8
(22) Date of filing: 23.11.1990
(51) Int. Cl.: C23F 4/02

(54) **Copper etch process and printed circuit formed thereby**
Verfahren zum Ätzen von Kupfer und dadurch hergestelltes gedrucktes Schaltbild
Procédé de décapage du cuivre et circuit imprimé fabriqué par ce procédé

(30) Priority: 20.12.1989 US 453543
(43) Date of publication of application: 17.07.1991
(73) Proprietor: TEXAS INSTRUMENTS INCORPORATED, Dallas Texas 75265 (US)
(72) Inventor: Douglas, Monte A., Coppell, Texas 75019 (US)
(74) Representative: Leiser, Gottfried, Dipl.-Ing.

(56) References cited:
- EP-A- 0 133 621
- EP-A- 0 150 358
- EP-A- 0 184 352
- EP-A- 0 219 697
- DE-A- 3 604 342
- IBM TECHNICAL DISCLOSURE BULLETIN, vol. 7, no. 9, February 1965, page 733, New YorK, US; A. REISMAN et al.: "A low temperature technique for selective area etching of semiconductor materials"
- JOURNAL OF THE ELECTROCHEMICAL SOCIETY, vol. 130, no. 8, 1983, pages 1777-1779; G.C. SCHWARTZ et al.: "Reactive ion etching of copper films"

## Description

This application is related by subject matter to EP-A- 0 433 983 having common title, inventor, and assignee as the instant application.

### FIELD OF THE INVENTION

The invention concerns methods for etching copper layers, especially copper layers overlying a layer of a second material, such as found in printed circuit fabrication and the seed copper layers used in printed circuit fabrication and in integrated circuit metallization layers, by photo-formed and photo-activated organic and amine radicals.

### BACKGROUND OF THE INVENTION

Patterning of a relatively thick copper layer or a thinner seed copper layer has been a requirement of printed circuit fabrication techniques. More recently, it has been desired to pattern thin copper layers in integrated circuit fabrication technology. Aluminum has been commonly used successfully in integrated circuit technology to form conductive leads between and across active elements of the integrated circuits, partly because aluminum has been found to be easily patterned by several techniques. However, as discussed by Hu, et al., in "Diffusion Barrier Studies for CU", 1986 IEEE V-MIC Conference, 9-10 June 1986, pages 181-187, copper offers several advantages over aluminum metallization layers in integrated circuits such as higher conductivity, better electromigration resistance, and reduced power consumption. As further discussed, however, in the same article, copper has a greater tendency to diffuse into silicon than aluminum. Satisfactory solution to this problem has, nevertheless, been found by the use of diffusion barriers between the solution and other layers of integrated circuits and the copper metallization layers.

Patterned etching of copper films has been accomplished, primarily in printed circuit fabrication, by wet processes wherein a protective, patterned film, such as a photoresist is applied to a copper layer and then a strong liquid etchant, usually an acid, is applied to etch the exposed copper down to the base material. This process presents several problems when applied to integrated circuit fabrication, such as the following. The wet processes are inherently "dirty" in that contaminants in the etchant can be introduced to the integrated circuit wafer. The wet etchants required are generally hazardous to operators by contact and inhalation of vapors produced thereby. Etching of copper requires etchants, high temperatures, or both which may damage the other layers of an integrated circuit. Etching of copper by wet processes is isotropic, making copper metallization for VLSI circuits extremely difficult due to inadequate critical dimension definition and control. Disposal of the waste products of wet etch processes is becoming more expensive.

Therefore, because of the increased desire to utilize copper metallization in integrated circuits and the problems inherent in known wet etch techniques, it has become more important to develop more effective etching processes and equipment for etching copper layers, especially as used in integrated circuit fabrication.

Sputtering techniques are utilized presently to remove copper from copper-doped aluminum films and therefore may have application to removing copper films. However, sputtering, the physical dislodging of copper atoms and clusters by high energy ion bombardment, does not exhibit selective removal of various films and will result in extreme build-up of residue in the reaction chamber, since copper is not converted to a volatile species. Also, sputter removal techniques are relatively slow, difficult to control, and exhibit insufficient selectivity to patterned masking layers and underlying thin films.

Dry etch processes, involving a plasma to form reactive agents such as a halogen, an amine, or an organic radical which react and form volatile copper products could be an approach to an effective etch process for copper which solves some of the problems encountered in other processes, particularly the redeposit of residue on reaction chambers. However, due to the known high melting and boiling points of the copper compounds that would be formed, coupled with the normal range of substrate temperatures associated with these plasma processes, it has been thought that volatilization would not occur and that these processes would be unsuccessful. Moreover, a plasma discharge produces a wide range of disassociated, reactive products that can combine homogeneously or heterogeneously to form a polymer residue. For example, hydrocarbon and chlorocarbon discharges produce heavy residues of polymer. The residue generates many particles. Also, if the reaction product of these processes does not volatize, it has been thought that the surface reaction would prevent further reaction of the copper bulk material below this surface. Some investigation of the reaction of chlorine with copper has been done as discussed by W. Sesselmann, et al., in "The Interaction of Chlorine with Copper", Surface Science, vol. 176(1986) pages 32-90. Some early investigation of ion etching of copper films is discussed by Schwartz, et al, in "Reactive Ion Etching of Copper Films", Journal of the Electochemical Society, Vol. 130, No. 8 (1983), pages 1777-1779.

### SUMMARY OF THE INVENTION

The Inventor has found that dry or dry/wet processes using organic and amine radicals generated and activated or energized by light and exposed to a copper film are effective processes for etching copper metallization layers, even in the environment of integrated circuit fabrication.

The Inventor has discovered that, especially at higher substrate or chamber temperatures, anisotropic volatilization of the copper amine or organic reaction product from unmasked areas is possible to achieve anisotropic dry etching of copper film. And, further, even when the copper amine or organic product is not volatile, complete reaction of a bulk copper film with the radical directionally or anisotropically occurs directionally or anisotropically to produce a copper amine or organo-copper reaction product which is easily removed anisotropically by a solvent or water wash. Most importantly, the copper amine or organic product is formed anisotropically so whether the product is removed by volatilization or wet solution, the patterned copper is not removed or undercut isotropically.

It is therefore an object of the invention to provide an etch process for copper films that is useful in fabrication processes for integrated circuits.

It is an object of the invention to sustain patterned critical dimension definition and control.

Further, it is an object of the invention to provide an etch process for copper films which does not require a strong wet etchant.

And it is also an object of the invention to provide photo-induced directional diffusion.

It is a further object of the invention to provide an etch process for copper films which avoids the contamination of process chambers and extremely low etch selectivity to mask and underlying layers caused by sputtering techniques.

It is a further object of the invention to provide an etch process for copper which is, essentially, a dry process. These and further benefits of the invention will be evident to one of ordinary skill in view of the drawing figures and detailed description of the embodiments to follow.

It is a further object of the invention to provide anisotropic etch techniques for copper films.

### BRIEF DESCRIPTION OF THE DRAWING FIGURES

Figure 1 is a schematic drawing of an embodiment of a reaction chamber as used in the process according to the instant invention.

Figures 2a and 2b are drawings representative of side views by electron microscopy of a semiconductor wafer during two stages of the etch process according to the instant invention.

### DETAILED DESCRIPTION OF THE INVENTION

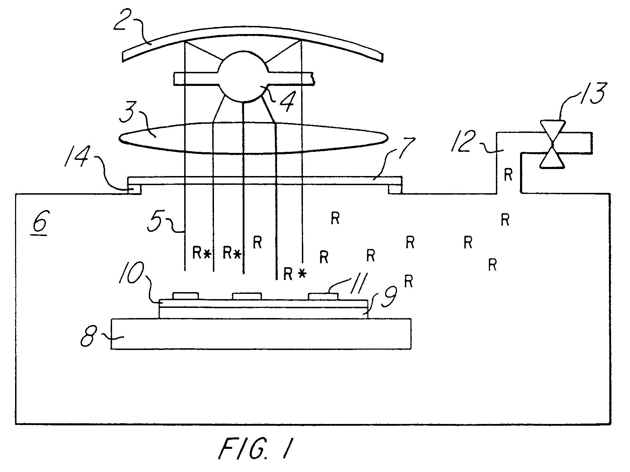

Referring to Figure 1, there is shown a sealed chamber 6 having a substrate holder 8, which normally has temperature controlled heating elements (not shown) for heating a substrate placed thereon. Shown on the substrate holder 8, is a drawing representation, not to scale, of a typical integrated circuit wafer having a substrate 9, for example a single crystal silicon substrate, a copper metal layer 10, and a patterned mask 11. Mask 11, in integrated circuit fabrication processes, would typically be a photo sensitive mask material of known types which is patterned and etched according to well-known photolithographic techniques. However, mask 11 may also be fabricated by techniques other than photolithography. Substrate holder 8 may contain controlled heating elements (not shown) for the purpose of heating the substrate 9 to a desired process temperature. The process temperature desired may be determined according to several factors. If a high degree of volatilization or complete volatilization of the combinative copper product is desired, a high process temperature is required. The exact temperature required is dependent upon the radical agent used. However, factored against utilization of such high process temperatures is the fact that the integrated circuit wafers processed may be damaged or destroyed by the temperatures required for significant volatilization. Of course, printed circuit substrates may not be so damaged by high process temperatures.

Again, referring to Figure 1, a high intensity light source 4, such as a filtered ultra violet source, e.g., a 1000 watt Hg/Xe lamp, is located above the chamber 6. Focusing elements 2 and 3 are arranged to direct the high intensity light through transparent window 7, which may be a quartz window, onto the surface of the masked copper layer 10 and 11. The window 7 is sealed, as by "0"-ring 14. It is pointed out that, although Figure 1 shows the high intensity light directed perpendicularly to the wafer, it has been found to be also effective if the chamber is arranged so that the light is directed at other angles to, and even parallel to, the wafer.

Inlet part 12, having valve 13, allows reactant R to enter the chamber 6 and contact the wafer 9, 10 and 11. Reactant R is an amine radical or organic radical, such as alkyl or phenyl radicals. The radical may be produced from an organic or amine compound, e.g., CH₃I by photochemical dissociation, microwave afterglow dissociation or plasma discharge dissociation, for example, as is known in the art. Also the halogen radical may be produced within the chamber by photochemical dissociation by, for example, introducing CH₃I to the high intensity ultraviolet light 5 from source 4. The organic or amine radical R is then light activated by high intensity light 5 and contacts the copper layer 10 and mask layer 11.

The etch process which occurs within the chamber 6, will follow two different methodologies, depending primarily upon the temperature at which the process occurs and the reactant used. An amine or organic parent molecule, P, is photo-dissociated to form radical species R. As the copper layer 10 is contacted by reactant radical R, the copper and radicals react at the surface to form a copper amine or organic copper compound. These reactions may be represented as:

### I. RADICAL FORMATION

P(gas) + h --> R (or R*), where P is a Parent molecule, R is an amine or organic radical, and R* is a light-activated radical.

### II. RADICAL FORMATION WITH Cu

R + Cu₍ₛ₎ --> CuR or,
R* + Cu₍ₛ₎ --> CuR or,
R_{ads} ... Cu₍ₛ₎ + h --> CuR, where (g) is gas, (s) is solid.

### III. CuR REMOVAL

CuR + S --> CuR₍ₛₒₗₙ₎ or,
CuR_{(ads)} --> CuR_{(g)} or,
CuR_{(ads)} + h --> CuR_{(g)}, where S is solvent, (soln) is solution, and (ads) is absorbed.

If CuR, under the conditions of the reaction, is volatile, then the product CuR is released as a vapor and may be pumped as a vapor from the chamber 6.

If however, product CuR is not volatile, the product remains on the copper layer surface. Surprisingly however, the Inventor has found that the reaction continues throughout the copper layer to form CuR. The surface reaction does not block reaction beneath the surface under the process conditions disclosed. After the reaction has then occurred throughout the copper layer 10, the resulting copper amine or organo-copper product CuR can be washed away using an appropriate solution such as water or acetone. The copper amine or organo-copper product will easily enter into solution.

Moreover, the diffusion of R, in CuR to react further with copper is believed to be photo-induced directional diffusion.

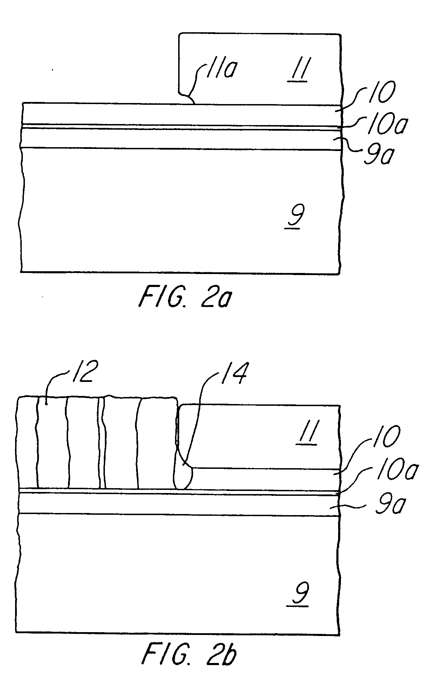

Figures 2a and 2b show a representation of an integrated circuit wafer using a copper metallization layer during two stages of the process according to the invention as has been observed by electron microscopy. The wafer of Figure 2a is shown before the etch process showing a silicon substrate 9, a silicon dioxide layer 9a, a titanium tungsten barrier layer 10a, and a copper layer 10.

A mask layer 11 is applied and patterned by well-known photolithography methods, for example, or by other known means. In this instance, a cantilevered resist overhang 11a is generated by an image-reversal development process.

Figure 2b depicts the same wafer after etch processing steps have been accomplished, as in the chamber of Figure 1, under the following conditions. The wafer (9, 10 and 11) may be deglazed as by a dilute nitric acid. A 1000 watt Mercury-Xenon lamp with a water filter was directed upon the wafer 9, 10 and 11. The water filter serves to extract most of the infrared light above 1.3nm while passing the deep ultraviolet light, down to 200 nm. The light was directed orthogonally to the wafer. The wafer was heated to a temperature of above 200°C. CH₃I, was introduced to the chamber, at 10 torr, at the rate of 100 sccm. The CH₃ was dissociated by the photo energy of the light source. The wafer was exposed to the CH3 radical for 15 minutes. After this time, Figure 2b shows that the entire copper layer which was not masked has reacted and expanded to about three times its previous thickness. The resulting product layer film 12 was found to be Cu(CH₃)₂. Further, a void 14, can be noted. The resulting film may be removed by a simple wash step.

## Claims

1. A method of etching a copper layer on a substrate to form patterned conductors comprising the steps of:
placing the substrate in a closed chamber;
masking areas of said copper layer, which areas are not intended to be etched;
introducing an organic radical producing species from the group of compounds containing alkyl, phenyl, and amine compounds, into said chamber so that the unmasked areas of copper are exposed to the organic radical producing species;
irradiating said chamber with a high intensity ultraviolet beam such that an organic radical is formed and reacts with said exposed copper to form an organic copper reaction product; and
removing said organic copper reaction product thereby leaving patterned copper conductors.

2. A method according to claim 1, further comprising the step of heating said substrate to a temperature at which said organic copper reaction product is substantially volatile.

3. A method according to claim 2, wherein said heating step comprises heating said substrate to a temperature above 200°C.

4. A method according to claim 1, further comprising the step of washing the substrate to remove the organic copper reaction product.

5. A method according to any preceding claim, wherein CH₃I is used as said organic radical producing species.

6. A method according to claim 5, further comprising the steps of introducing said CH₃I into said chamber at a pressure of 10 torr; irradiating the chamber using a 1000W Mercury-Xenon lamp adapted to produce a beam of radiation with a range of wavelengths between 1.3nm to 200nm, thereby creating the CH₃· radical; and exposing the wafer to the CH₃· radical for about fifteen minutes thereby producing the organic-copper reaction product Cu(CH₃)₂.

7. A method according to claim 6, further comprising producing said beam within said range by filtering the radiation from the light through a water filter.

8. A printed circuit having metallisation formed by the method of any preceding claim.

9. An integrated circuit having metallisation formed by the method of any of claims 1 to 7.

## Patentansprüche

1. Verfahren zum Ätzen einer Kupferschicht auf einem Substrat zur Herstellung strukturierter Leiter, enthaltend die Schritte:
Anbringen des Substrats in einer geschlossenen Kammer;
Maskieren von Bereichen der Kupferschicht, wobei die Bereiche nicht geätzt werden sollen;
Einführen eines organischen Radikals, das Spezies aus der Gruppe von Verbindungen erzeugt, die Alkyl-, Phenyl- und Aminverbindungen enthält, in die Kammer, so daß die unmaskierten Bereiche des Kupfers dem Spezies erzeugenden organischen Radikal ausgesetzt werden;
Bestrahlen der Kammer mit einem Ultraviolett-Strahlenbündel mit hoher Intensität, so daß ein organisches Radikal erzeugt wird und mit dem freiliegenden Kupfer reagiert, damit ein Organo-Kupfer-Reaktionsprodukt entsteht; und
Entfernen des Organo-Kupfer-Reaktionsprodukts, so daß dadurch strukturierte Kupferleiter zurückbleiben.

2. Verfahren nach Anspruch 1, ferner enthaltend den Schritt des Erhitzens des Substrats auf eine Temperatur, bei der das Organo-Kupfer-Reaktionsprodukt im wesentlichen flüchtig ist.

3. Verfahren nach Anspruch 1, bei welchem der Erhitzungsschritt das Erhitzen des Substrats auf eine Temperatur über 200°C enthält.

4. Verfahren nach Anspruch 1, ferner enthaltend den Schritt des Waschens des Substrats zum Entfernen des Organo-Kupfer-Reaktionsprodukts.

5. Verfahren nach einem der vorhergehenden Ansprüche, bei welchem CH₃I als das Spezies erzeugende organische Radikal benutzt wird.

6. Verfahren nach Anspruch 5, ferner enthaltend die Schritte des Einführens des CH₃I in die Kammer bei einem Druck von 10 Torr; des Bestrahlens der Kammer unter Verwendung einer 1000 W-Quecksilber-Xenon-Lampe, die geeignet ist, ein Bestrahlungs-Strahlenbündel mit einem Wellenlängenbereich zwischen 1,3 nm bis 200 nm zu erzeugen, wodurch das CH₃-Radikal erzeugt wird; und des Aussetzens des Plättchens dem CH₃-Radikal für etwa 15 Minuten, wodurch das organische Kupferreaktionsprodukt Cu (CH₃)₂ erzeugt wird.

7. Verfahren nach Anspruch 6, ferner enthaltend das Erzeugen des Strahlenbündels innerhalb des Wellenlängenbereichs durch Filtern der von dem Licht ausgehenden Strahlung durch ein Wasserfilter.

8. Gedruckte Schaltung mit einer mittels des Verfahrens nach einem der vorhergehenden Ansprüche gebildeten Metallisierung.

9. Integrierte Schaltung mit einer nach dem Verfahren gemäß einem der Ansprüche 1 bis 7 gebildeten Metallisierung.

## Revendications

1. Procédé de décapage d'une couche de cuivre sur un substrat pour former une configuration de conducteurs, comportant les étapes qui consistent :
à placer le substrat dans une chambre fermée ;
à masquer les zones de ladite couche de cuivre ne devant pas être décapées ;
à introduire un corps chimique produisant un radical organique choisi dans le groupe des composés comprenant les composés d'alkyles, de phényles et d'amines dans ladite chambre, de telle sorte que les zones non masquées du cuivre soient exposées au corps chimique produisant un radical organique ;
à soumettre ladite chambre à un faisceau de rayonnements ultraviolets de haute intensité, de telle sorte que le radical organique soit formé et réagisse avec ledit cuivre exposé afin de former un produit de réaction constitué par un composé organique du cuivre ; et
à retirer ledit produit de réaction constitué par un composé organique cuivre, laissant ainsi une configuration de conducteurs en cuivre.

2. Procédé selon la revendication 1, comportant en outre l'étape qui consiste à chauffer ledit substrat à une température à laquelle ledit produit de réaction constitué par un composé organique du cuivre est sensiblement volatil.

3. Procédé selon la revendication 2, dans lequel ladite étape de chauffage comporte le chauffage dudit substrat à une température supérieure à 200°C.

4. Procédé selon la revendication 1, comportant en outre l'étape qui consiste à laver ledit substrat pour retirer le produit de réaction constitué par un composé organique du cuivre.

5. Procédé selon l'une quelconque des revendications précédentes, dans lequel on utilise du CH₃I comme corps chimique produisant un radical organique.

6. Procédé selon la revendication 5, comportant en outre les étapes qui consistent à introduire ledit CH₃I dans ladite chambre sous une pression de 10 torr ; à soumettre la chambre à un rayonnement en utilisant une lampe au mercure-xénon de 1000 W adaptée pour produire un faisceau de rayonnement dans un intervalle de longueur d'onde compris entre 1,3 nm à 200 nm, créant ainsi le radical CH₃ ; à exposer la plaque au radical CH₃ pendant environ quinze minutes, produisant ainsi le produit de réaction constitué par un composé organique du cuivre, Cu(CH₃)₂.

7. Procédé selon la revendication 6, comportant en outre la production dudit faisceau dans ledit intervalle de longueur d'onde en filtrant le rayonnement provenant de la lumière à travers un filtre à eau.

8. Circuit imprimé comportant une métallisation formée par le procédé suivant l'une quelconque des revendications précédentes.

9. Circuit intégré comportant une métallisation formée par le procédé suivant l'une quelconque des revendications 1 à 7.
